# EUROPEAN PATENT APPLICATION

(11) **EP 1 901 348 A2**
(43) Date of publication of application: **19.03.2008**
(21) Application number: 07253640.2
(22) Date of filing: 13.09.2007
(51) Int. Cl.: H01L 23/24

(54) **Method for sealing microcomponent**

(30) Priority: 13.09.2006 JP 2006247688
(71) Applicant: Shin-Etsu Chemical Co., Ltd., Tokyo (JP)
(72) Inventor: Miyoshi, Kei, Annaka-shi, Gunma-ken (JP); Yamakawa, Naoki, Annaka-shi, Gunma-ken (JP)
(74) Representative: Stoner, Gerard Patrick

(57) **Abstract**

A microcomponent on a substrate is sealed with a liquid silicone composition in the cured state by forming a channel or recess in a substrate, placing a microcomponent at the center of the channel-delimited region or recess, applying a droplet of liquid silicone composition so that the droplet is delimited by the perimeter of the channel or recess and held in a convex shape by the surface tension of the liquid, and curing the liquid silicone composition.

## Description

### TECHNICAL FIELD

This invention relates to a method for sealing a microcomponent (e.g., semiconductor, LED, capacitor, transistor or resistor) resting on a substrate with a liquid silicone composition in the cured state.

### BACKGROUND

With regard to workpieces including chips such as semiconductor chips, LED, capacitors, transistors, and resistors resting on substrates, a number of methods for coating or sealing them with silicone resins or silicone rubber are employed for protecting the chips from degradation by external elements such as humidity, heat, ultraviolet radiation, and vibration.

The liquid silicone composition used in this sealing application should be thixotropic so that it may not spread beyond the desired range to be sealed after curing. It should also have a fluidity enough to effectively penetrate into the gap between the substrate and the chip to achieve a complete seal over the chip. While these two contradictory properties are both valuable, primary importance is usually placed on fluidity, in view of ease of operation, so that in practice a silicone sealant resulting from curing of a liquid silicone composition often spreads beyond the desired range.

In the field where optical characteristics are required, however, an extra spread of silicone sealant is undesired. The performance of optical elements is dictated by whether or not a seal is proper. The spread of a silicone sealant beyond the desired range means that the sealant fails to assume the desired shape, which is problematic. In another field where optical characteristics are not required, the seal should meet reliability, and in some case, esthetic appearance.

Reference should be made to EP 1424363B or US 2005-01212008A (corresponding to JP-A 2004-186168).

An aim herein is to provide new and useful methods for sealing a microcomponent or chip resting on a substrate with a liquid silicone composition, whereby the liquid silicone composition is held within a desired region on the substrate while taking advantage of the good flow property thereof, so that a cured product of a good shape can be formed.

The invention addresses a method for sealing a chip by covering a chip resting on a substrate with a droplet of liquid silicone composition, and curing the liquid silicone composition for sealing the chip onto the substrate. The inventors have found that an improvement can be made by establishing the following situation:
(1) a situation wherein a channel is formed in an upper surface of the substrate so as to define and surround a predetermined region to be sealed with the cured liquid silicone composition, the chip is placed at the center of the region, and a droplet of liquid silicone composition is applied over the region, whereby the droplet of liquid silicone composition is delimited at the top edge of the channel inner wall and held in a convex shape within the region so that the liquid silicone composition may not flow into the channel, by the surface tension of the liquid silicone composition,
(2) a situation wherein a recess is formed in a predetermined region of the substrate to be sealed with the cured liquid silicone composition, the chip is placed at the center of the recess, and a droplet of liquid silicone composition is applied to the recess, whereby the droplet of liquid silicone composition is delimited by the circumferential wall of the recess and held in a convex shape by the surface tension of the liquid silicone composition, or
(3) a situation wherein a weir of predetermined height is provided on an upper surface of the substrate to define as a recess a predetermined region of the substrate to be sealed with the cured liquid silicone composition, the chip is placed at the center of the recess, and a droplet of liquid silicone composition is applied to the recess, whereby the droplet of liquid silicone composition is delimited by the circumferential wall of the recess and held in a convex shape by the surface tension of the liquid silicone composition.
In either of these situations, the droplet of liquid silicone composition held in a convex shape is cured.
Since the liquid silicone composition used in the method is effectively flowable, the method takes advantage thereof so that the liquid silicone composition may penetrate into the gap between the substrate and the chip and narrow interstices within the chip, but may not spread beyond the predetermined region. Since the liquid silicone composition is held within the desired range on the substrate, a cured product or silicone sealant of a good shape can be formed.

The invention provides microcomponent sealing methods defined below.
[1] In a method for sealing a microcomponent by covering a microcomponent resting on a substrate with a droplet of liquid silicone composition, and curing the liquid silicone composition for sealing the microcomponent onto the substrate, the improvement comprising the steps of:
   forming a channel in an upper surface of the substrate so as to define and surround a predetermined region to be sealed with the cured liquid silicone composition, the channel having inner and outer walls,
   placing the microcomponent at the center of said region, and
   applying the droplet of liquid silicone composition over said region, the droplet of liquid silicone composition being delimited at the upper edge of the channel inner wall and held in a convex shape within said region so that the liquid silicone composition may not flow into the channel, by the surface tension of the liquid silicone composition, before the curing of the liquid silicone composition.
[2] In a method for sealing a microcomponent by covering a microcomponent resting on a substrate with a droplet of liquid silicone composition, and curing the liquid silicone composition for sealing the microcomponent onto the substrate, the improvement comprising the steps of:
   forming a recess in a predetermined region of the substrate to be sealed with the cured liquid silicone composition, the recess having a circumferential wall,
   placing the microcomponent at the center of said recess, and
   applying the droplet of liquid silicone composition to said recess, the droplet of liquid silicone composition being delimited by the circumferential wall of the recess and held in a convex shape by the surface tension of the liquid silicone composition, before the curing of the liquid silicone composition.
[3] In a method for sealing a microcomponent by covering a microcomponent resting on a substrate with a droplet of liquid silicone composition, and curing the liquid silicone composition for sealing the microcomponent onto the substrate, the improvement comprising the steps of:
   providing a weir of predetermined height on an upper surface of the substrate to define as a recess a predetermined region of the substrate to be sealed with the cured liquid silicone composition, the recess having a circumferential wall,
   placing the microcomponent at the center of said recess, and
   applying the droplet of liquid silicone composition to said recess, the droplet of liquid silicone composition being delimited by the circumferential wall of the recess and held in a convex shape by the surface tension of the liquid silicone composition, before the curing of the liquid silicone composition.
[4] The method of [3], wherein said weir is made of a solder resist, dam material or adhesive-bearing polymeric sheet.
[5] The method of any one of [1] to [4], wherein the liquid silicone composition is a heat-curable liquid silicone composition.
[6] The method of any one of [1] to [5], wherein the liquid silicone composition has a viscosity of up to 100 Pa-s.
[7] The method of any one of [1] to [6], wherein the microcomponent comprises a semiconductor chip.
[8] The method of [7], wherein the semiconductor chip is a light-emitting diode.

It is understood that in the second and third embodiments, the recess is coextensive with the region to be sealed.

Thus, a present proposal in general is that a surrounding inward- or outward-facing step formation of the substrate surface be provided, corresponding to the region to be covered by the droplet, and inhibits flow of the uncured sealing composition beyond the desired region.

An effectively flowable liquid silicone composition can be used, with the advantage that the liquid silicone composition may penetrate into the gap between the substrate and the chip and narrow interstices within the chip, but does not spread beyond the predetermined region, that is, the liquid silicone composition is held within the desired region. Then a cured product or silicone sealant of a good shape can be formed. A substrate having a chip, typically a semiconductor chip rested and sealed thereon is obtainable which has reliability and durability. Particularly when a relatively small droplet is held, it takes a dome shape (i.e., substantially hemispherical) so that a cured product of dome shape is obtained. The substrate having the present characteristic surface formation surrounding the droplet-covered sealed region is an aspect of the invention and a novel product.

### BRIEF DESCRIPTION OF THE DRAWINGS

FIG. 1 schematically illustrates a first embodiment of the invention wherein a channel is formed in a substrate, and a chip is sealed with a liquid silicone composition in the cured state, FIG. 1A being a plan view and FIG. 1B being a cross-sectional view.
FIG. 2 schematically illustrates a second embodiment wherein a recess is formed in a substrate, and a chip is sealed with a liquid silicone composition in the cured state, FIG. 2A being a plan view and FIG. 2B being a cross-sectional view.
FIG. 3 schematically illustrates another example of the second embodiment wherein a recess is formed in a substrate, and a chip is sealed with a liquid silicone composition in the cured state, FIG. 3A being a plan view and FIG. 3B being a cross-sectional view.
FIG. 4 schematically illustrates a third embodiment wherein a weir is provided on a substrate to define a recess, and a chip is sealed with a liquid silicone composition in the cured state, FIG. 4A being a plan view and FIG. 4B being a cross-sectional view.
FIG. 5 schematically illustrates another example of the third embodiment wherein a weir is provided on a substrate to define a recess, and a chip is sealed with a liquid silicone composition in the cured state, FIG. 5A being a plan view and FIG. 5B being a cross-sectional view.

### FURTHER EXPLANATIONS; OPTIONS AND PREFERENCES

As used herein, the term "microcomponent" refers to microelectronic components or chips including semiconductor chips such as light-emitting diodes (LED) and chip transistors, chip capacitors, and chip resistors, but is not limited thereto. The term "microcomponent" is used as interchangeable with the term "chip," the chip is often used herein for the sake of simplicity.

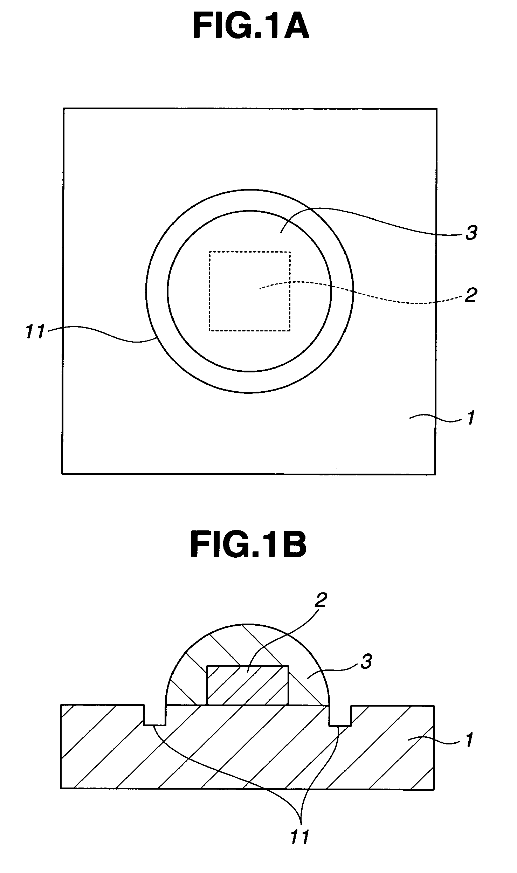

Typically the substrate is supported horizontal. The plan view of FIG. 1A, for example, is also referred to as a horizontal direction. The term "upper" surface used in connection with the substrate is as viewed in the cross-section of FIG. 1B, for example.

The invention relates to a method for sealing a chip by covering a chip resting on a substrate with a droplet of liquid silicone composition, and curing the liquid silicone composition for sealing the chip onto the substrate.

In a first embodiment of the invention, a channel is formed in an upper surface of the substrate so as to define and surround a predetermined region to be sealed with the cured liquid silicone composition, the channel having inner and outer walls. The chip is placed at the center of the region. A droplet of liquid silicone composition is applied over the region. By the surface tension of the liquid silicone composition, the droplet of liquid silicone composition is delimited at the upper edge of the channel inner wall and held in a convex shape within the region so that the liquid silicone composition may not flow into the channel. In this state, the droplet of liquid silicone composition is cured. In the first embodiment, if a droplet of liquid silicone composition having a predetermined volume is moderately placed on the region, then by virtue of its surface tension, the droplet is delimited and held at the upper edge of the channel inner wall without overflowing into the channel. The droplet is formed to a convex shape within the region.

The first embodiment is effective, for example, when a chip, typically a semiconductor chip, die-bonded onto a substrate is covered with a droplet of liquid silicone composition and sealed therewith by curing the droplet. Referring to FIG. 1, a channel 11 is formed in an upper surface of a substrate 1 so as to define and surround a predetermined region to be sealed with a cured liquid silicone composition 3. The channel is annular as viewed in the plane view of FIG. 1A and rectangular as viewed in the transverse cross-sectional view of FIG. 1B, having inner and outer walls and a bottom. A chip 2 is placed at the center of the region (delimited by the inner wall of channel 11). A droplet of liquid silicone composition is applied over the region so as to take the same shape as the finally cured composition 3. By the surface tension of the liquid silicone composition, the droplet of liquid silicone composition is delimited at the upper edge of the channel inner wall and held in a convex shape, specifically a dome shape in FIG. 1, within the region so that the liquid silicone composition may not flow into channel 11. In this state, the droplet of liquid silicone composition is cured whereby chip 2 on substrate 1 is sealed with the cured silicone composition or silicone sealant 3.

The channel may be formed in the substrate, for example, by machining the substrate. Where the substrates are made of polymeric materials such as resins, a substrate having a channel formed during substrate molding may be used. The channel is preferably formed as a complete annulus so that it defines and surrounds the predetermined region to be sealed with a cured silicone composition along its entire circumference. The shape of the channel as viewed in the plane view is preferably circular or ellipsoidal although a polygonal shape such as tetragonal, pentagonal, hexagonal or octagonal may also be applicable. The shape of the channel as viewed in the transverse cross-sectional view is preferably rectangular although another shape such as hemi-circle, hemi-ellipsoid or inverted triangle is also acceptable.

The channel is fully effective even when it is of very small size. For ease of formation, the channel preferably has a depth of at least 10 µm, and more preferably at least 50 µm, and a width of at least 10 µm, and more preferably at least 50 µm. No particular upper limits may be imposed on the depth and width. Usually, the depth is equal to or less than 500 µm, and more specifically equal to or less than 300 µm, and the width is equal to or less than 500 µm, and more specifically equal to or less than 300 µm. Particularly when an LED is to be sealed, the region to be sealed with a cured silicone composition generally has an area of about 0.006 to 2 cm².

In a second embodiment, a recess is formed in a predetermined region of the substrate to be sealed with the cured liquid silicone composition. The recess has a surround (circumferential) wall and a bottom. A chip is placed at the center of the recess. A droplet of liquid silicone composition is applied to the recess, whereby the droplet of liquid silicone composition is delimited by the circumferential wall of the recess and held in a convex shape by the surface tension of the liquid silicone composition. In this state, the droplet of liquid silicone composition is cured.

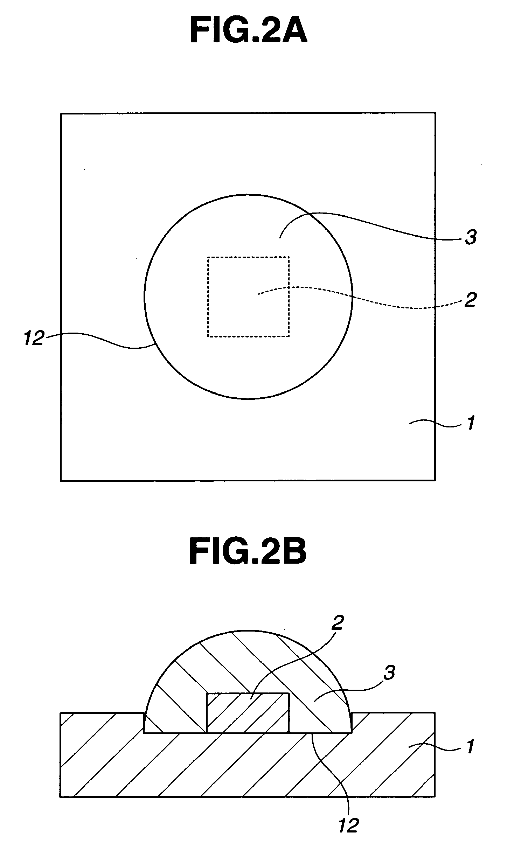

The second embodiment is effective, for example, when a chip, typically a semiconductor chip, die-bonded onto a substrate is covered with a droplet of liquid silicone composition and sealed therewith by curing the droplet. Referring to FIG. 2, a recess 12 is formed in a predetermined region of a substrate 1 to be sealed with a cured liquid silicone composition 3. The recess is circular as viewed in the plane view of FIG. 2A and rectangular as viewed in the transverse cross-sectional view of FIG. 2B, having a circumferential wall and a bottom. A chip 2 is placed at the center of the recess 12 (or bottom). A droplet of liquid silicone composition is applied to the recess 12 so as to take the same shape as the finally cured composition 3. The droplet of liquid silicone composition is delimited and held by the circumferential wall of the recess and at the same time, held in a convex shape, specifically a dome shape in FIG. 2, by the surface tension of the liquid silicone composition. In this state, the droplet of liquid silicone composition is cured whereby chip 2 on substrate 1 is sealed with the cured silicone composition or silicone sealant 3.

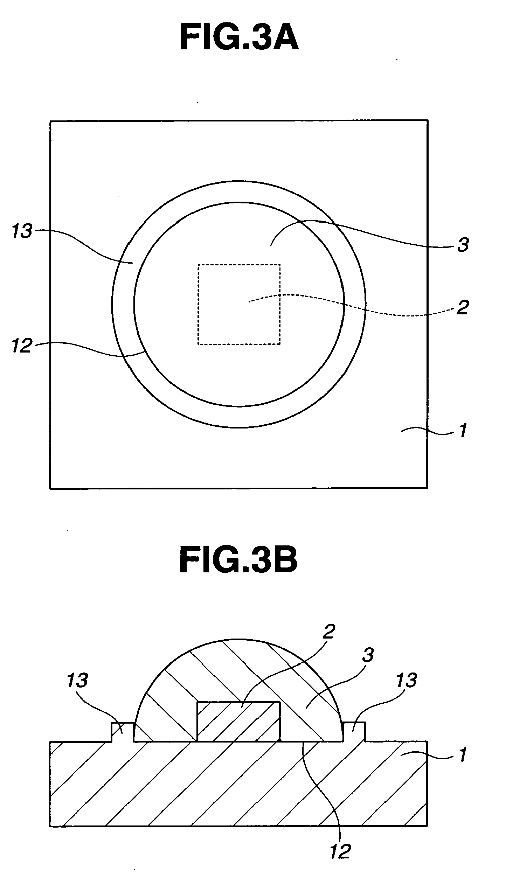

In a modification of the second embodiment, as shown in FIG. 3, a ridge 13 is raised from an upper surface of a substrate so as to delimit the predetermined region on the substrate surface and to define a recess 12. Likewise, chip 2 on substrate 1 is sealed with the cured silicone composition or silicone sealant 3.

The recess may be formed in the substrate, for example, by machining the substrate. Where the substrates are made of polymeric materials such as resins, a substrate having a recess formed during substrate molding may be used.

The shape of the recess as viewed in the plane view is preferably circular or ellipsoidal although a polygonal shape such as tetragonal, pentagonal, hexagonal or octagonal may also be applicable. The shape of the recess as viewed in the transverse cross-sectional view is preferably rectangular although another shape such as inverted trapezoid or arcuate bottom (recess with a spherical or ellipsoidal bottom) is also acceptable.

In a third embodiment, a weir of predetermined height is provided on an upper surface of the substrate to define as a recess a predetermined region of the substrate to be sealed with the cured liquid silicone composition. It has a surround (circumferential) wall and a bottom. A chip is placed at the center of the recess. A droplet of liquid silicone composition is applied to the recess, whereby the droplet of liquid silicone composition is delimited by the circumferential wall of the recess and held in a convex shape by the surface tension of the liquid silicone composition. In this state, the droplet of liquid silicone composition is cured.

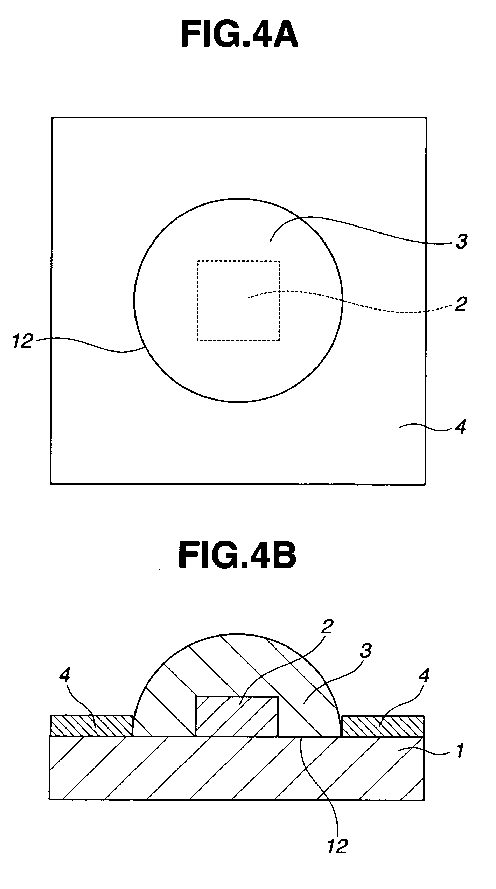

The third embodiment is effective, for example, when a chip, typically a semiconductor chip, die-bonded onto a substrate is covered with a droplet of liquid silicone composition and sealed therewith by curing the droplet. Referring to FIG. 4, a weir 4 of predetermined height or thickness is provided on an upper surface of a substrate 1 to define as a recess 12 a predetermined region of the substrate to be sealed with the cured liquid silicone composition. The recess 12 is circular as viewed in the plane view of FIG. 4A and rectangular as viewed in the transverse cross-sectional view of FIG. 4B, having a circumferential wall and a bottom. A chip 2 is placed at the center of the recess 12 (or bottom). A droplet of liquid silicone composition is applied to the recess 12 so as to take the same shape as the finally cured composition 3. The droplet of liquid silicone composition is delimited and held by the circumferential wall of the weir or recess and at the same time, held in a convex shape, specifically a dome shape in FIG. 4, by the surface tension of the liquid silicone composition. In this state, the droplet of liquid silicone composition is cured whereby chip 2 on substrate 1 is sealed with the cured silicone composition or silicone sealant 3.

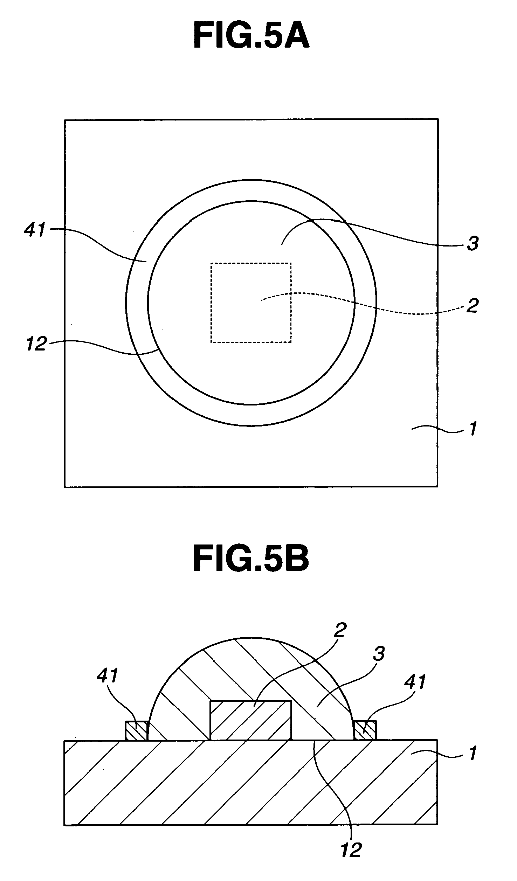

In a modification of the third embodiment, as shown in FIG. 5, an annular weir 41 is raised from an upper surface of a substrate so as to delimit the predetermined region on the upper surface and to define a recess 12. Likewise, chip 2 on substrate 1 is sealed with the cured silicone composition or silicone sealant 3.

The weir may be made of a solder resist, dam material or adhesive-bearing polymeric sheet. In the case of solder resist, a resist pattern may be printed by screen printing, stencil printing or the like, and cured to form the weir. In the case of adhesive-bearing polymeric sheet, a Teflon® or PET sheet bearing pressure-sensitive adhesive on one surface may be used to form a weir. The weir preferably has a height or thickness of at least 10 µm and more preferably at least 50 µm. No particular upper limit may be imposed on the height. Usually, the height is equal to or less than 1 mm.

The shape of the recess as viewed in the plane view is preferably circular or ellipsoidal although a polygonal shape such as tetragonal, pentagonal, hexagonal or octagonal may also be applicable. The shape of the recess as viewed in the transverse cross-sectional view is preferably rectangular although another shape such as inverted trapezoid is also acceptable.

In the second and third embodiments, the recess should have a size enough to receive the chip therein. Usually, the recess has a depth of 5 to 50 µm and a diameter (or maximum size in a horizontal direction) of 0.02 to 1 cm. Particularly when an LED is to be sealed, the recess bottom to be sealed with a cured silicone composition generally has an area of about 0.03 to 0.8 cm².

The liquid silicone composition used herein encompasses all types of liquid silicone compositions commonly used as ordinary silicone materials including one type of crosslinking through condensation reaction occurring by moisture, another type of crosslinking through hydrosilylation reaction at room temperature or elevated temperature, a further type of crosslinking reaction occurring upon UV exposure, and still another type of crosslinking in which decomposition reaction of peroxide generates radicals. Among others, liquid silicone compositions of the heat curing type are preferred in view of fast cure, cure in the dark, and line adaptability.

The silicone sealant encompasses all types of silicone materials including a silicone rubber resulting from a silicone rubber composition and exhibiting rubber elasticity after curing, a silicone resin resulting from a silicone resin composition and exhibiting plasticity after curing, and a silicone gel resulting from a silicone gel composition and becoming a soft gel form after curing. When LEDs are to be sealed, liquid silicone compositions capable of forming transparent cured products are often used.

The viscosity of the liquid silicone composition is not particularly limited. In view of chip sealing efficiency and especially fluidity, the composition preferably has a viscosity of equal to or less than 100 Pa-s, and more preferably equal to or less than 30 Pa-s. The viscosity is preferably at least 0.1 Pa-s, and more preferably at least 10 Pa-s.

Basically, the liquid silicone composition need not be thixotropic. However, a thixotropic composition may be used since it is advantageous in operation. Notably, use of compositions which are so thixotropic that stringing occurs, or memory marks or follow patterns are left after coating should be avoided. A typical agent capable of imparting thixotropy to silicone compositions is fumed silica. A thixotropic effect is expected when the thixotropic agent is added to the silicone composition in a small amount, specifically 0.5 to 10 parts by weight per 100 parts by weight of the composition (exclusive of thixotropic agent). This is suitable particularly when transparent cured products are desired.

The substrate may be made of any desired material. Suitable substrates include FR-4 substrates, ceramic substrates such as glass substrates, metal substrates such as aluminum substrates, rubber substrates, and polymeric substrates such as resin substrates as long as chips can be mounted thereon.

In the illustrated embodiments, the cured silicone composition (or silicone sealant) has a dome shape. The convex shape of the cured product or droplet is not limited to the dome. The invention is applicable to a thin film of silicone sealant resulting from the composition spreading over a relatively wider extent on the substrate until complete curing. In this case, since the perimeter of droplet is retained by the inner wall upper edge of the channel or the circumferential wall of the recess, the cured composition (or silicone sealant) assumes a curved convex shape in which the chip is sealed.

### EXAMPLE

Experiments are given below for further illustrating the invention.

### Experiments 1 and 2

LED-sealing silicone composition KER-2500 A and B is available from Shin-Etsu Chemical Co., Ltd. Parts A and B were intimately mixed. The mixture was deaerated in vacuum for completely removing entrained air, before it was filled in a syringe. Separately, a pressure-sensitive adhesive Teflon® tape of 80 µm thick was attached to a float glass plate. Using a cutter, the tape was incised to define a circle having a diameter of 2 mm. The circle portion was removed to leave a recess, followed by cleaning with toluene. From the syringe, an amount (shown in Table 1) of the silicone composition was injected dropwise into the recess whereupon the droplet was cured at 120°C for one hour. The diameter (maximum size in a horizontal direction) and height of the cured product were measured by a slide gauge. The results are shown in Table 1.

### Experiments 3 and 4

Parts A and B of LED-sealing silicone composition KER-2500 (Shin-Etsu Chemical Co., Ltd.) were intimately mixed. To 100 parts by weight of the mixture was added 5 parts by weight of fumed silica having a specific surface area of 300 m²/g and surface treated with dimethyldichlorosilane. This was intimately mixed on an agitator. The mixture was deaerated in vacuum for completely removing entrained air, before it was filled in a syringe. Separately, a pressure-sensitive adhesive Teflon® tape of 80 µm thick was attached to a float glass plate. Using a cutter, the tape was incised to define a circle having a diameter of 2 mm. The circle portion was removed to leave a recess, followed by cleaning with toluene. From the syringe, an amount (shown in Table 1) of the silica-laden silicone composition was injected dropwise into the recess whereupon the droplet was cured at 120°C for one hour. The diameter (maximum size in a horizontal direction) and height of the cured product were measured by a slide gauge. The results are shown in Table 1.

### Comparative Experiments 1 and 2

Parts A and B of LED-sealing silicone composition KER-2500 (Shin-Etsu Chemical Co., Ltd.) were intimately mixed. The mixture was deaerated in vacuum for completely removing entrained air, before it was filled in a syringe. From the syringe, an amount (shown in Table 1) of the silicone composition was injected dropwise onto a float glass plate which had been cleaned with toluene whereupon the droplet was cured at 120°C for one hour. The diameter (maximum size in a horizontal direction) and height of the cured product were measured by a slide gauge. The results are shown in Table 1.

### Comparative Experiments 3 and 4

Parts A and B of LED-sealing silicone composition KER-2500 (Shin-Etsu Chemical Co., Ltd.) were intimately mixed. To 100 parts by weight of the mixture was added 5 parts by weight of fumed silica having a specific surface area of 300 m²/g and surface treated with dimethyldichlorosilane. This was intimately mixed on an agitator. The mixture was deaerated in vacuum for completely removing entrained air, before it was filled in a syringe. From the syringe, an amount (shown in Table 1) of the silica-laden silicone composition was injected dropwise onto a float glass plate which had been cleaned with toluene whereupon the droplet was cured at 120°C for one hour. The diameter (maximum size in a horizontal direction) and height of the cured product were measured by a slide gauge. The results are shown in Table 1.

**Table 1**

| | Experiment | | | | Comparative Experiment | | | |
|---|---|---|---|---|---|---|---|---|
| | 1 | 2 | 3 | 4 | 1 | 2 | 3 | 4 |
| Droplet amount (mg) | 1.1 | 1.0 | 1.0 | 1.3 | 1.1 | 1.4 | 1.2 | 1.1 |
| Diameter (mm) | 2.12 | 2.04 | 1.98 | 2.02 | 4.05 | 4.66 | 3.65 | 3.82 |
| Height (mm) | 0.29 | 0.22 | 0.30 | 0.34 | 0.07 | 0.10 | 0.13 | 0.12 |
| Height/diameter | 0.137 | 0.108 | 0.152 | 0.168 | 0.017 | 0.021 | 0.036 | 0.031 |

## Claims

1. A method of sealing a microcomponent by covering a microcomponent resting on a substrate with a droplet of liquid silicone composition, and curing the liquid silicone composition to seal the microcomponent onto the substrate, **characterised in that**
a channel is provided in an upper surface of the substrate so as to define and surround a predetermined region to be sealed with the cured liquid silicone composition, the channel having inner and outer walls, with the microcomponent at the centre of said region, and the method comprises
applying the droplet of liquid silicone composition over said region, the droplet of liquid silicone composition being delimited in its extent at the edge of the channel inner wall and held in a convex shape within said region by the surface tension of the liquid silicone composition, before the curing of the liquid silicone composition.

2. A method of sealing a microcomponent by covering a microcomponent resting on a substrate with a droplet of liquid silicone composition, and curing the liquid silicone composition to seal the microcomponent onto the substrate, **characterised in that**
a recess is provided in a predetermined region of the substrate to be sealed with the cured liquid silicone composition, the recess having a surround wall, with the microcomponent at the centre of said recess, and the method comprises
applying the droplet of liquid silicone composition to said recess, the droplet of liquid silicone composition being delimited in its extent by the surround wall of the recess and held in a convex shape by the surface tension of the liquid silicone composition, before the curing of the liquid silicone composition.

3. A method of sealing a microcomponent by covering a microcomponent resting on a substrate with a droplet of liquid silicone composition, and curing the liquid silicone composition to seal the microcomponent onto the substrate, **characterised in that**
a raised weir is provided on an upper surface of the substrate forming a surround wall to define as a recess a predetermined region of the substrate to be sealed with the cured liquid silicone composition, with the microcomponent at the centre of said recess, and the method comprises
applying the droplet of liquid silicone composition to said recess, the droplet of liquid silicone composition being delimited in its extent by the surround wall of the recess and held in a convex shape by the surface tension of the liquid silicone composition, before the curing of the liquid silicone composition.

4. A method of claim 3, wherein said weir is made of a solder resist, dam material or adhesive-bearing polymeric sheet.

5. A method of any one of claims 1 to 4, wherein the liquid silicone composition is a heat-curable liquid silicone composition.

6. A method of any one of claims 1 to 5, wherein the liquid silicone composition has a viscosity of not more than 100 Pa-s.

7. A method of any one of claims 1 to 6, wherein the microcomponent comprises a semiconductor chip.

8. A method of claim 7, wherein the semiconductor chip is a light-emitting diode.
